# EUROPÄISCHE PATENTSCHRIFT

(11) **EP 2 288 029 B1**
(45) Veröffentlichungstag und Bekanntmachung des Hinweises auf die Patenterteilung: **24.04.2013**
(21) Anmeldenummer: 10167303.6
(22) Anmeldetag: 25.06.2010
(51) Int. Cl.: H03K 17/96

(54) **Kapazitive Sensoranordnung**
Capacitative sensor assembly
Agencement de capteur capacitif

(30) Priorität: 20.07.2009 DE 102009027851
(43) Veröffentlichungstag der Anmeldung: 23.02.2011
(73) Patentinhaber: Huf Hülsbeck & Fürst GmbH & Co. KG, 42551 Velbert (DE)
(72) Erfinder: Van Gastel, Peter, 42699 Solingen (DE); Lindic, Iko, 45149 Essen (DE)
(74) Vertreter: Zenz

(56) Entgegenhaltungen:
- WO-A2-2007/104540
- DE-A1-102007 047 716
- DE-B3-102006 053 572

## Beschreibung

Die Erfindung betrifft eine kapazitive Sensoranordnung mit einer Sensorelektrode, mit deren Hilfe das Eindringen eines Objekts in einen Raum vor der Sensorelektrode erfasst werden soll, einer mit der Sensorelektrode gekoppelten Steuer- und Auswerteschaltung, die eine Änderung der Kapazität der Sensorelektrode gegenüber einem Referenzpotential erfasst, indem sie die Sensorelektrode mit einer vorgegebenen Frequenz periodisch auf- und entlädt und wenigstens einen Parameter eines vom periodischen Laden und Entladen der Sensorelektrode abhängigen Strom- oder Spannungsverlaufs zur Erfassung der Kapazitätsänderung auswertet, einer Hintergrundelektrode, einer zwischen der Sensorelektrode und der Hintergrundelektrode angeordneten Schirmelektrode, die über die Steuer- und Auswerteschaltung derart mit der Sensorelektrode gekoppelt ist, dass ihr Potential dem Potential der Sensorelektrode im wesentlichen nachgeführt wird, wobei sich ein Detektionsbereich der Sensoranordnung in den Raum vor der Sensorelektrode erstreckt.

Eine kapazitive Sensoranordnung mit einer Sensorelektrode, mit deren Hilfe die Annäherung eines Objekts erfasst werden soll, und mit einer mit der Sensorelektrode gekoppelten Steuer- und Auswerteschaltung, die eine Änderung der Kapazität der Sensorelektrode gegenüber Masse erfasst, indem sie die Sensorelektrode mit einer vorgegebenen Frequenz periodisch wiederholt mit einer Betriebsspannung koppelt und wenigstens einen Parameter eines vom periodischen Laden und Entladen der Sensorelektrode abhängigen Strom- oder Spannungsverlaufs zur Erfassung der Kapazitätsänderung auswertet, ist beispielsweise aus dem US-Patent 5,730,165 bzw. der entsprechenden Patentschrift DE 196 81 725 B4 bekannt. Der Parameter eines vom periodischen Laden und Entladen der Sensorelektrode abhängigen Strom- oder Spannungsverlaufs ist dabei eine über einem Kondensator messbare Spannung, die von der auf dem Kondensator angesammelten Ladung abhängt, wobei diese Ladung dadurch angesammelt wird, dass periodisch wiederholt die Sensorelektrode durch Koppeln mit der Betriebsspannung aufgeladen und anschließend durch Koppeln mit dem Kondensator über diesen entladen wird. Ein anderer derartiger kapazitiver Sensor ist aus der Patentschrift EP 1 339 025 B1 bekannt.

Eine kapazitive Sensoranordnung mit einer Sensorelektrode, mit einer beabstandet hinter der Sensorelektrode angeordneten Masse-Hintergrundelektrode und mit einer Schirmelektrode, die zwischen der Sensorelektrode und der Masse-Hintergrundelektrode angeordnet ist und die über eine Steuer- und Auswerteschaltung derart mit der Sensorelektrode gekoppelt ist, dass ihr Potential dem Potential der Sensorelektrode nachgeführt wird, ist beispielsweise aus den Veröffentlichungen WO 2007/104540 A2, EP 0 518 836 A1, US 6,825,752 B2, DE 101 31 243 C1 und DE 10 2006 044 778 A1 bekannt. Das aus diesen Druckschriften bekannte Vorsehen einer Schirmelektrode zwischen der Sensorelektrode und der auf Masse-Potential liegenden Hintergrundelektrode hat den Vorteil, dass die Empfindlichkeit des so gebildeten kapazitiven Sensors gegenüber Veränderungen im Raum vor der Sensorelektrode, beispielsweise durch Einbringen von Objekten, erhöht wird. Dies liegt vor allem daran, dass sich das von der Sensorelektrode ausbreitende Feld stärker in den Raum vor der Sensorelektrode (Detektionsbereich) erstreckt, weil nicht mehr - wie bei fehlender Schirmelektrode - ein großer Teil des Feldes zu der auf Masse-Potential liegenden Hintergrundelektrode kurzgeschlossen wird. Aufgrund des Umstands, dass die Schirmelektrode derart mit der Sensorelektrode gekoppelt ist, dass sie deren Potential nachgeführt wird, entsteht das starke elektrische Feld zwischen der Schirmelektrode und der Hintergrundelektrode; vor allem aber bildet sich praktisch kein Feld aus zwischen der Sensorelektrode und der potentialmäßig nachgeführten Schirmelektrode.

Die bekannte Anordnung von Sensorelektrode, Schirmelektrode und Hintergrundelektrode ist üblicherweise von einem elektrischen Isolator, beispielsweise einem Kunststoff, umhüllt, so dass sich eine Isolatorschicht, beispielsweise Kunststoffschicht, auf der Sensorelektrode und somit zwischen der Sensorelektrode und dem zu überwachenden Raum vor der Sensorelektrode, das heißt dem Detektionsbereich, befindet. Es hat sich gezeigt, dass bei einem Einsatz einer solchen kapazitiven Sensoranordnung in einer mit Schmutz und Feuchte belasteten Umgebung, beispielsweise an der Außenhülle eines Kraftfahrzeugs (z.B. als Annäherungssensor in einem Türaußengriff), unerwünschte Kapazitätsänderungen durch eine Kontamination mit Wasser oder Feuchte auf der Außenfläche der Kunststoffumhüllung der Sensoranordnung auftreten können, die im ungünstigsten Fall dazu führen, dass die Sensoranordnung fälschlicherweise das Eindringen eines Objekts in den Detektionsbereich im Raum vor der Sensorelektrode feststellt.

Der Erfindung liegt daher die Aufgabe zugrunde, bei einer Sensoranordnung der eingangs genannten Art ein derartiges durch Feuchtekontamination der Sensoraußenfläche bewirktes fehlerhaftes Ansprechen zu vermeiden oder zu minimieren.

Erfindungsgemäß wird diese Aufgabe durch eine kapazitive Sensoranordnung mit den Merkmalen des Anspruchs 1 gelöst.

Die erfindungsgemäße kapazitive Sensoranordnung umfasst eine sich entlang einer ersten Koordinatenlinie erstreckende Sensorelektrode, mit deren Hilfe das Eindringen eines Objekts in einen Raum vor der Sensorelektrode erfasst werden soll. Die Koordinatenlinie ist beispielsweise eine gerade Koordinatenlinie eines kartesischen Koordinatensystems; sie kann aber auch im Raum gekrümmt sein. Die kapazitive Sensoranordnung weist ferner eine mit der Sensorelektrode gekoppelten Steuer- und Auswerteschaltung auf, die eine Änderung der Kapazität der Sensorelektrode gegenüber einem Referenzpotential erfasst, indem sie die Sensorelektrode mit einer vorgegebenen Frequenz periodisch auf- und entlädt und wenigstens einen Parameter eines vom periodischen Laden und Entladen der Sensorelektrode abhängigen Strom- oder Spannungsverlaufs zur Erfassung der Kapazitätsänderung auswertet. Das periodische Auf- und Entladen führt sie beispielsweise aus, indem sie die Sensorelektrode mit der vorgegebenen Frequenz periodisch wiederholt mit einem vorgegebenen Potential, beispielsweise dem Betriebsspannungspotential, koppelt. Der Spannungsverlauf kann beispielsweise der Spannungsverlauf am Anschluss der Sensorelektrode sein. Der Parameter kann beispielsweise eine Spannung, die über einem Ladung ansammelnden Kondensator gemessen wird, oder eine bestimmte Anzahl von Perioden des Ladens und Entladens bis zum Überschreiten einer Schaltschwelle durch eine an der Sensorelektrode gemessene Spannung sein. Die kapazitive Sensoranordnung weist ferner eine sich parallel zu der Sensorelektrode erstreckende Hintergrundelektrode und eine zwischen der Sensorelektrode und der Hintergrundelektrode angeordnete Schirmelektrode, die über die Steuer- und Auswerteschaltung derart mit der Sensorelektrode gekoppelt ist, dass ihr Potential dem Potential der Sensorelektrode im wesentlichen nachgeführt wird, auf. Die Schirmelektrode ist über die Steuer- und Auswerteschaltung derart mit der Sensorelektrode gekoppelt, dass sie keinen Einfluss auf die gegenüber dem Referenzpotential gemessene Kapazitätsänderung der Sensorelektrode hat. Mit dem Begriff des "Nachführens" soll hier zum Ausdruck gebracht werden, dass das Potential der Schirmelektrode nicht gleich dem Potential der Sensorelektrode zu sein braucht und dass es einen zeitlichen Versatz zwischen dem Verlauf des Potentials der Sensorelektrode und dem Potential der Schirmelektrode geben kann. Mit den Worten "im Wesentlichen" soll darüber hinaus zum Ausdruck gebracht werden, dass die Schirmelektrode nicht über die vollen Perioden des Ladens und Entladens der Sensorelektrode dem Potential der Sensorelektrode folgen muss; es genügt, wenn sie diesem Potential zumindest in Teilabschnitten der Perioden folgt, beispielsweise während des Aufladens der Sensorelektrode deren Potential folgt und während des Entladens der Sensorelektrode auf das Masse-Referenzpotential abfällt, während das Potential der Sensorelektrode noch auf einem von Masse verschiedenen Potential verbleibt. Die Hintergrundelektrode wird beispielsweise auf ein konstantes Potential, wie Masse oder Betriebsspannung, gelegt. Alternativ kann die Hintergrundelektrode periodisch mit der vorgegebenen Frequenz abwechselnd auf Masse und ein weiteres Potential, beispielsweise die Betriebsspannung gelegt werden, wobei dies vorzugsweise komplementär zur Sensorelektrode erfolgt, wie dies beispielsweise in der parallel anhängigen Patentanmeldung der Anmelderin mit dem Titel "Kapazitive Sensoranordnung mit einer Sensorelektrode, einer Schirmelektrode und einer Hintergrundelektrode" beschrieben ist. Die Sensorelektrode, die Schirmelektrode und die Hintergrundelektrode sind entlang einer zur ersten Koordinatenlinie senkrechten zweiten Koordinatenlinie hintereinander angeordnet, wobei sich ein Detektionsbereich der Sensoranordnung in der Richtung der zweiten Koordinatenlinie in den Raum vor der Sensorelektrode sowie in einem vorgegebenen Winkelbereich (α) zu beiden Seiten der von der ersten und der zweiten Koordinatenlinie aufgespannten Ebene erstreckt. Die Sensorelektrode ist von Isolatormaterialien umgeben, die zwischen der Sensorelektrode und dem Detektionsbereich in der Art eines halbkreisförmigen oder halbelliptischen Zylinders angeordnet sind, wobei die Zylindermittelachse in der Ebene liegt, die von der ersten und der zweiten Koordinatenlinie aufgespannt wird, wobei die Isolatormaterialien zwischen dem Detektionsbereich und der Sensorelektrode zumindest eine die Sensorelektrode unmittelbar umgebende Kunststoffschicht einer ersten Dicke und eine in einem vorgegebenen Abstand angeordnete äußere Kunststoffschicht einer zweiten Dicke umfassen, wobei die Isolatormaterialien so angeordnet sind, dass die relative Dielektrizitätskonstante mit zunehmender Entfernung von der Sensorelektrode zunächst einen relativ hohen Wert der umgebenden Kunststoffschicht annimmt, dann auf einen sich dem Wert 1 annähernden Wert (beispielsweise den von Luft) abfällt und dann wieder auf einen relativ hohen Wert der äußeren Kunststoffschicht ansteigt.

Es zeigte sich, dass bei einer gezielten Schaffung eines Zwischenraums zwischen der die kontaminierte Außenfläche bildenden Kunststoffschicht und der die Sensorelektrode umhüllenden Kunststoffschicht mit einer dem Wert 1 angenäherten Dielektrizitätskonstante die störenden Einflüsse der Feuchtekontamination verringert oder vermieden werden konnten. Gleichzeitig gestattet die erfindungsgemäße Anordnung der Isolatormaterialien im Vergleich zu einer massiven Kunststoffumhüllung der Sensorelektroden eine relativ geringe Baugröße, d.h. relativ geringe Querschnittsabmessungen der Sensorelektrodenumhüllung, bei gleicher Störunempfindlichkeit.

Eine bevorzugte Ausführungsform ist **dadurch gekennzeichnet, dass** sich zwischen der die Sensorelektrode umgebenden Kunststoffschicht und der äußeren Kunststoffschicht ein gasgefüllter Zwischenraum befindet, dessen Breite dem vorgegebenen Abstand entspricht und dessen relative Dielektrizitätskonstante sich dem Wert 1 annähert. Dieser Zwischenraum wird beispielsweise von einem Luftspalt oder mehreren Luftspalten mit radialen und/oder zylindrischen Kunststoffzwischenwänden gebildet. Bei dieser Ausführungsform lässt sich der gewünschte Verlauf der relativen Dielektrizitätskonstante auf einfache Weise herstellen. Alternativ oder teilweise kann der gasgefüllte Zwischenraum von einem geschäumten Kunststoffbereich gebildet werden. Beispielsweise könnten sowohl die die Sensorelektrode umgebende Kunststoffschicht als auch die äußere Kunststoffschicht und der Zwischenraum aus einem Kunststoffmaterial gefertigt sein, wobei die äußeren und die an der Elektrode anliegenden Bereiche nahezu vollständig aus dem Kunststoffmaterial bestehen und das Kunststoffmaterial in dem Zwischenraum stark aufgeschäumt ist. Die die Sensorelektrode umgebende Kunststoffschicht und/oder die äußere Kunststoffschicht können jeweils aus mehreren gleichartigen oder unterschiedlichen Kunststoffschichten bestehen.

Bei einer bevorzugten Weiterbildung der Erfindung liegt der vorgegebene Abstand zwischen der die Sensorelektrode umgebenden Kunststoffschicht und der äußeren Kunststoffschicht im Bereich zwischen 30 % und 90%, vorzugsweise im Bereich zwischen 50 % und 70%, des Abstands der äußeren Oberfläche der äußeren Kunststoffschicht von der Oberfläche der Sensorelektrode.

Vorzugsweise liegen die erste Dicke, das heißt die Dicke der die Sensorelektrode unmittelbar umgebenden Kunststoffschicht, und die zweite Dicke, das heißt die Dicke der in einem vorgegebenen Abstand angeordneten äußeren Kunststoffschicht, im Bereich zwischen 0,2 mm und 2 mm.

Der vorgegebene Abstand zwischen der die Sensorelektrode umgebenden Kunststoffschicht und der äußeren Kunststoffschicht liegt vorzugsweise im Bereich zwischen 0,5 mm und 10 mm, vorzugsweise im Bereich zwischen 1 mm und 4 mm.

Der Detektionsbereich der Sensoranordnung erstreckt sich in einem vorgegebenen Winkelbereich (α) zu beiden Seiten der von der ersten und der zweiten Koordinatenlinie aufgespannten Ebene, der vorzugsweise zwischen jeweils 40° bis 130° liegt.

Bei einer bevorzugten Ausführungsform sind die Sensorelektrode auf der der Schirmelektrode zugewandten Seite sowie die Schirmelektrode und die Hintergrundelektrode von einem Kunststoffmantel umhüllt, wobei der Kunststoffmantel die Elektroden trägt und ihre Position fixiert. Die Hintergrundelektrode ist beispielsweise als ebene Platte ausgebildet ist, die in einer zu der zweiten Koordinatenlinie senkrechten Ebene symmetrisch hinter der Sensorelektrode angeordnet ist. Dabei erstreckt sich die Hintergrundelektrode in der zur ersten und zur zweiten Koordinatenlinie senkrechten Richtung bis zur äußeren Kunststoffschicht der in der Art eines halbkreisförmigen oder halbelliptischen Zylinders angeordneten Isolatormaterialien. Vorzugsweise weist hierbei die Schirmelektrode in der zur ersten und zur zweiten Koordinatenlinie senkrechten Richtung eine Breite auf, die größer als die der Sensorelektrode, aber geringer als die der Hintergrundelektrode ist.

Eine bevorzugte Ausführungsform der kapazitiven Sensoranordnung ist **dadurch gekennzeichnet, dass** die vorgegebene Frequenz im Bereich zwischen 50 kHz und 5 MHz, vorzugsweise zwischen 100 kHz und 1 MHz, liegt.

Vorteilhafte und/oder bevorzugte Ausführungsformen sind in den Unteransprüchen gekennzeichnet.

Im folgenden wird die Erfindung anhand von in den Zeichnungen dargestellten bevorzugten Ausführungsbeispielen näher erläutert. In den Zeichnungen zeigen:
Figur 1 eine Prinzipskizze eines Querschnitts durch eine erfindungsgemäße Sensoranordnung und einer angekoppelten Steuer- und Auswerteschaltung:;
Figuren 2A und 2B schematische Querschnitte durch alternative Querschnittsformen und Anordnungen der Sensorelektroden; und
Figuren 3A und 3B schematische Querschnitte durch Sensoranordnungen mit alternativen Ausbildungen des Zwischenraums zwischen der die Sensorelektrode umgebenden Kunststoffschicht und der äußeren Kunststoffschicht.

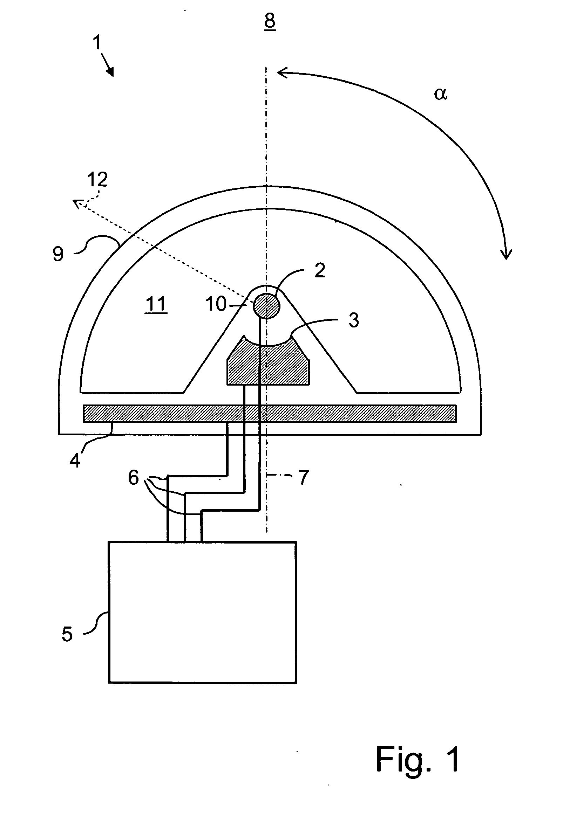

Figur 1 zeigt eine schematische Darstellung eines Querschnitts durch eine erfindungsgemäße Sensoranordnung 1 mit einer angekoppelten Steuer- und Auswerteschaltung 5. Bei der Sensoranordnung 1 handelt es sich um ein in der Richtung quer zur Zeichnungsebene der Figur 1 langgestrecktes Profil. Die Sensoranordnung 1 umfasst eine sich entlang einer ersten Koordinatenlinie erstreckende Sensorelektrode 2. Die Koordinatenlinie verläuft senkrecht zur Zeichnungsebene der Figur 1 und stellt beispielsweise eine Koordinatenlinie eines kartesischen Koordinatensystems dar. Bei anderen Ausführungsformen braucht die Koordinatenlinie nicht geradlinig zu sein; sie kann auch im Raum gekrümmt verlaufen. So kann es sich bei dem in Figur 1 geschnitten dargestellten Profil um ein flexibles Profil handeln. Die Sensorelektrode 2 hat bei dem in Figur 1 skizzierten Ausführungsbeispiel einen kreisförmigen Querschnitt. Bei anderen Ausführungsformen kann sie einen abweichenden, beispielsweise einen rechteckigen Querschnitt haben. Parallel zu der Sensorelektrode 2 ist eine Hintergrundelektrode 4 angeordnet. Zwischen der Sensorelektrode 2 und der Hintergrundelektrode 4 befindet sich eine Schirmelektrode 3. Sensorelektrode 2, Schirmelektrode 3 und Hintergrundelektrode 4 sind entlang einer zur ersten Koordinatenlinie senkrechten zweiten Koordinatenlinie hintereinander angeordnet. Bei dem in Figur 1 dargestellten Ausführungsbeispiel verläuft die zweite Koordinatenlinie vertikal in der Zeichnungsebene. Die erste Koordinatenlinie und die zweite Koordinatenlinie spannen eine Ebene auf, die in Figur 1 durch die gestrichelt dargestellte Linie 7 angedeutet ist. Bei dem in Figur 1 dargestellten Ausführungsbeispiel ist die Hintergrundelektrode 4 durch eine ebene Platte gebildet; die zwischen der Sensorelektrode 2 und der Hintergrundelektrode 4 angeordnete Schirmelektrode 3 ist in der Richtung quer zu der Ebene 7 breiter als die Sensorelektrode 2, aber schmaler als die Hintergrundelektrode 4.

In Figur 1 ist schematisch angedeutet, dass die drei Elektroden 2, 3 und 4 jeweils über Signalleitungen 6 mit der Steuer- und Auswerteschaltung 5 verbunden sind. Die Hintergrundelektrode 4 ist beispielsweise auf Masse gelegt. Die Steuer- und Auswerteschaltung 5 führt ein periodisches Auf- und Entladen der Sensorelektrode 2 mit einer vorgegebenen Frequenz aus und wertet wenigstens einen Parameter eines sich vom periodischen Laden und Entladen der Sensorelektrode 2 abhängigen Strom- oder Spannungsverlaufs zur Erfassung der Änderung der Kapazität der Sensorelektrode 2 gegenüber Masse aus. Die Schirmelektrode 3 ist über die Steuer- und Auswerteschaltung 5 derart mit der Sensorelektrode 2 gekoppelt, dass ihr Potenzial dem Potenzial der Sensorelektrode 2 im Wesentlichen nachgeführt wird. Die Ansteuerung der Elektrodenanordnung und die Bestimmung der Kapazitätsänderung kann beispielsweise so erfolgen, wie es in der parallel anhängigen deutschen Patentanmeldung Nr. 10 2009 031 824.0 der Anmelderin mit dem Titel "Kapazitive Sensoranordnung mit einer Sensorelektrode, einer Schirmelektrode und einer Hintergrundelektrode" beschrieben ist.

Um die relative Lage der Sensorelektrode 2, der Schirmelektrode 3 und der Hintergrundelektrode 4 zu fixieren und die Elektroden elektrisch von der Umgebung zu isolieren, sind die drei Elektroden von einer Isolatorschicht, vorzugsweise einer Kunststoffschicht, umhüllt. Die Kunststoffumhüllung ist zwischen der Sensorelektrode 2 und dem Detektionsbereich des Raums 8 vor der Sensoranordnung 1 in der Art eines halbkreisförmigen Zylinders angeordnet. Die Zylindermittelachse liegt etwa in der Ebene 7, die von der ersten und der zweiten Koordinatenlinie aufgespannt wird (Die Umhüllung kann auch geringfügig asymmetrisch zu der Ebene 7 angeordnet sein). Der Detektionsbereich erstreckt sich in den Raum 8 vor der Sensoranordnung 1 ausgehend von der Ebene 7 um einen Winkel α nach rechts und nach links von dieser Ebene, wobei der Winkel α die Breite des Detektionsbereichs der Sensoranordnung 1 definiert. Der Winkelbereich α liegt beispielsweise zwischen 40° und 130° Grad zu beiden Seiten der Ebene 7. Bei dem in Figur 1 dargestellten Ausführungsbeispiel beträgt der Winkelbereich α, in dem sich der Detektionsbereich zu beiden Seiten der von der ersten und der zweiten Koordinatenlinie aufgespannten Ebene 7 erstreckt, etwa 90° Grad.

Bei dem in Figur 1 dargestellten Ausführungsbeispiel ist innerhalb der Kunststoffumhüllung ein Hohlraum 11 zwischen einer die Sensorelektrode 2 unmittelbar umgebenden Kunststoffschicht 10 und einer äußeren Kunststoffschicht 9 ausgebildet, so dass dann, wenn man sich beispielsweise entlang der in Figur 1 gestrichelt dargestellten Linie 12 ausgehend von der Oberfläche der Sensorelektrode 2 in Richtung des Detektionsbereichs bewegt, die relative Dielektrizitätskonstante der die Sensorelektrode 2 umgebenden Isolatormaterialien zunächst einen relativ hohen Wert der die Elektrode 2 umgebenden Kunststoffschicht 10 annimmt, dann in dem Zwischenraum 11 auf einen sich dem Wert 1 annähernden Wert abfällt (beispielsweise auf den Wert der Dielektrizitätskonstante von Luft) und dann wieder auf einen relativ hohen Wert der äußeren Kunststoffschicht 9 ansteigt. Die relative Dielektrizitätskonstante der Kunststoffschichten liegt beispielsweise im Bereich von 2 bis 5, insbesondere bei etwa 4.

Das in Figur 1 dargestellte Profil der Sensoranordnung hat beispielsweise eine Länge von einigen Zentimetern bis hin zu etwa einem Meter. Die Breite des Profils beträgt beispielsweise 15 mm und die Höhe etwa 10 mm. Die Dicke der äußeren Kunststoffschicht 9 beträgt beispielsweise 1 mm. Die Sensorelektrode 2 ist beispielsweise mit einer Kunststoffschicht 10 von 0,5 mm Dicke bedeckt. Die Breite des Zwischenraums liegt zwischen etwa 4 mm und 2 mm.

Die Elektroden 2, 3 und 4 können beispielsweise aus in das Kunststoffmaterial eingebetteten Metallstreifen bestehen. Bei einer bevorzugten Ausführungsform bestehen die Elektroden aus einem leitfähigen Kunststoff. Bei einem längeren Profil, bei dem die Elektroden 2, 3 und 4 aus einem leitfähigen Kunststoff hergestellt sind, kann es vorgesehen sein, dass innerhalb der Elektroden Leitungsdrähte aus Metall eingebettet sind. Die Elektroden 2, 3 und 4 werden beispielsweise an einem Ende des Profils mit den Leitungen 6 zur Steuer- und Auswerteschaltung 5 verbunden.

Bei dem in Figur 1 gezeigten Beispiel erstreckt sich die Hintergrundelektrode 4 über die gesamte Breite des Profils. Dies verleiht dem Profil zusätzliche Stabilität.

Die in der Ebene 7 hintereinander angeordneten Elektroden 2, 3 und 4 können in unterschiedlicher Weise ausgebildet und angeordnet sein. Auch können die Elektroden 2, 3 und 4 jeweils aus mehreren parallel angeordneten Elektroden bestehen.

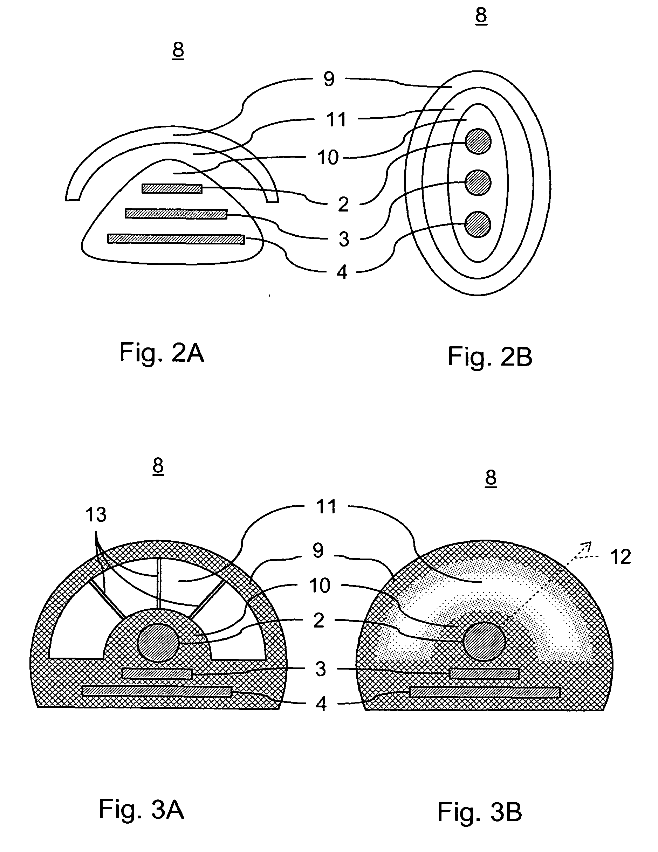

In den Figuren 2A und 2B sind schematisch weitere denkbare Anordnungen der drei Elektroden und der sie umgebenden Kunststoffschichten dargestellt. Figur 2A zeigt eine schematische Anordnung von drei als ebene Platten ausgebildeten Elektroden 2, 3 und 4, wobei die Sensorelektrodenplatte 2 ein Streifen mit der geringsten Breite und die Hintergrundelektrodenplatte 4 ein Streifen mit der größten Breite ist. Die drei Elektrodenstreifen sind von einer Kunststoffschicht 10 umhüllt und in dieser fixiert. Von dieser Kunststoffumhüllung 10 durch einen Spalt 11 beabstandet ist zwischen der Sensorelektrode 2 und dem den Detektionsbereich enthaltenden Raum 8 eine äußere Kunststoffschicht 9 angeordnet.

Figur 2B zeigt eine weitere Möglichkeit, bei der die drei entlang der zweiten Koordinatenlinie hintereinander angeordneten Elektroden 2, 3 und 4 jeweils als Metalldrähte mit einem kreisförmigen Querschnitt ausgebildet sind. Die drei parallel zueinander angeordneten Elektrodendrähte 2, 3 und 4 bilden mit der Kunststoffumhüllung 10 eine Anordnung, die etwa einem 3-adrigen Flachbandkabel entspricht. Beabstandet durch den Zwischenraum 11 ist die Elektrodenanordnung von einer äußeren Kunststoffumhüllung 9 umschlossen. Die in Figur 2B dargestellte Sensoranordnung ist symmetrisch; das heißt, bei Wechsel der Ansteuerung kann sowohl die in Figur 2 oben dargestellte Elektrode als Sensorelektrode dienen (wie dargestellt) als auch die unten dargestellte Elektrode. Der Detektionsbereich kann sich somit sowohl nach oben in den Raum 8 als auch nach unten erstrecken.

Die Figuren 3A und 3B zeigen schematische Querschnittsansichten durch beispielhafte Profile der erfindungsgemäßen Sensoranordnung. Figur 3A und 3B enthalten dieselbe Anordnung der Elektroden 2, 3 und 4. Eine Sensorelektrode 2 mit kreisförmigem Querschnitt ist über einer plattenförmigen Schirmelektrode 3 mit einer etwas größeren Breite und diese wiederum über einer plattenförmigen Hintergrundelektrode 4 mit der größten Breite angeordnet. Die in Figur 3A dargestellte Ausbildung der Kunststoffumhüllung ähnelt der der Figur 1. Allerdings enthält der Zwischenraum 11 mehrere entlang des Profils radial nach außen verlaufende Zwischenwände 13, die dem Profil eine höherer mechanische Stabilität verleihen, insbesondere einem Eindrücken der äußeren Kunststoffwandung 9 entgegenwirken. Die Zwischenräume 11 sind beispielsweise luftgefüllt.

Bei der Ausführungsform gemäß Figur 3B ist der Zwischenraum zwischen der äußeren Kunststoffwandung 9 und der Kunststoffumhüllung 10 der Sensorelektrode 2 mit verschiedenen Kunststoffschichten gefüllt, wobei die inneren Kunststoffschichten zunehmend stark geschäumt sind. Beispielsweise könnte der Raum 11 mit einem Polyurethan- oder Polystyrol-Schaum gefüllt sein (Polystyrol-Schaum hat eine relative Dielektrizitätskonstante von etwa 1,03). Bewegt man sich entlang des Pfeiles 12 ausgehend von der Oberfläche der Sensorelektrode 2 radial nach außen, so hat der Kunststoff zunächst eine relativ hohe Dielektrizitätskonstante (beispielsweise 4), woraufhin die Dielektrizitätskonstante zunächst von Kunststoffschicht zu Kunststoffschicht abfällt, im Inneren des Zwischenraums 11 einen Wert von nahezu 1 erreicht, und dann anschließend wieder Schicht für Schicht ansteigt, bis in der äußeren Kunststoffschicht 9 wieder der hohe Wert (von beispielsweise 4) erreicht wird.

Sofern die erfindungsgemäßen Sensorprofilleisten flexibel sein sollen, wird ein entsprechend flexibler Kunststoff für die Umhüllung eingesetzt. Darüber hinaus können leitfähige Kunststoffprofile als Sensorelektroden verwendet, die gegebenenfalls von Metallleitern durchzogen. Sämtliche Bestandteile des Profils können beispielsweise koextrudiert werden.

Die genauen Abmessungen des Sensorprofils, insbesondere die Dicken der Kunststoffschichten und die Breite des Zwischenraums hängen vom jeweils gewünschten Einsatzgebiet, insbesondere von den Abmessungen des Detektionsbereichs ab. Wird ein derartiger Sensor beispielsweise als Annäherungssensor in einem Türaußengriff verwendet, so erstreckt sich der Detektionsbereich maximal wenige Zentimeter über die Außenfläche des Sensors hinaus. In diesem Fall kann die Sensoranordnung beispielsweise eine Höhe von wenigen Millimetern aufweisen, wobei der Zwischenraum (beispielsweise Luftspalt) zwischen der die Sensorelektrode 2 umgebenden Kunststoffschicht 10 und der äußeren Kunststoffschicht 9 nur 1 mm bis 2 mm beträgt. Die Sensoranordnung kann auch beispielsweise für einen die Annäherung eines Fußes erfassenden Sensors am unteren Rand des Hecks eines Kraftfahrzeugs eingesetzt werden, wobei mit einer solchen, "Fußschalter" genannten Sensoranordnung beispielsweise das Öffnen des Kofferraums oder einer Heckklappe ausgelöst werden kann. In einem solchen Fall erstreckt sich der Detektionsbereich beispielsweise etwa 20 cm ausgehend von der Oberfläche der Sensoranordnung 1. Das Sensorprofil hat bei dieser Anordnung eine Höhe von beispielsweise einem Zentimeter, und der Zwischenraum zwischen der die Sensorelektrode 2 umgebenden Kunststoffschicht 10 und der äußeren Kunststoffschicht 9 beträgt hier 3 mm bis 5 mm.

## Patentansprüche

1. Kapazitive Sensoranordnung (1) mit
einer sich entlang einer ersten Koordinatenlinie erstrekkenden Sensorelektrode (2), mit deren Hilfe das Eindringen eines Objekts in einen Raum (8) vor der Sensorelektrode (2) erfasst werden soll,
einer mit der Sensorelektrode (2) gekoppelten Steuer- und Auswerteschaltung (5), die eine Änderung der Kapazität der Sensorelektrode (2) gegenüber einem Referenzpotential erfasst, indem sie die Sensorelektrode (2) mit einer vorgegebenen Frequenz periodisch auf- und entlädt und wenigstens einen Parameter eines vom periodischen Laden und Entladen der Sensorelektrode (2) abhängigen Strom- oder Spannungsverlaufs zur Erfassung der Kapazitätsänderung auswertet,
einer sich parallel zu der Sensorelektrode (2) erstreckenden Hintergrundelektrode (4),
einer zwischen der Sensorelektrode (2) und der Hintergrundelektrode (4) angeordneten Schirmelektrode (3), die über die Steuer- und Auswerteschaltung (5) derart mit der Sensorelektrode (2) gekoppelt ist, dass ihr Potential dem Potential der Sensorelektrode (2) im wesentlichen nachgeführt wird,
wobei die Sensorelektrode (2), die Schirmelektrode (3) und die Hintergrundelektrode (4) entlang einer zur ersten Koordinatenlinie senkrechten zweiten Koordinatenlinie hintereinander angeordnet sind, wobei sich ein Detektionsbereich der Sensoranordnung (1) in der Richtung der zweiten Koordinatenlinie in den Raum (8) vor der Sensorelektrode (2) sowie in einem vorgegebenen Winkelbereich (α) zu beiden Seiten der von der ersten und der zweiten Koordinatenlinie aufgespannten Ebene (7) erstreckt,
wobei die Sensorelektrode (2) umgeben ist von Isolatormaterialien, die zwischen der Sensorelektrode (2) und dem Detektionsbereich in der Art eines halbkreisförmigen oder halbelliptischen Zylinders angeordnet sind, wobei die Zylindermittelachse in der Ebene (7) liegt, die von der ersten und der zweiten Koordinatenlinie aufgespannt wird, wobei die Isolatormaterialien zwischen dem Detektionsbereich und der Sensorelektrode (2) zumindest eine die Sensorelektrode (2) unmittelbar umgebende Kunststoffschicht (10) einer ersten Dicke und eine in einem vorgegebenen Abstand angeordnete äußere Kunststoffschicht (9) einer zweiten Dicke umfassen, wobei die Isolatormaterialien so angeordnet sind, dass die relative Dielektrizitätskonstante mit zunehmender Entfernung von der Sensorelektrode (2) zunächst einen relativ hohen Wert der umgebenden Kunststoffschicht (10) annimmt, dann auf einen sich dem Wert 1 annähernden Wert abfällt und dann wieder auf einen relativ hohen Wert der äußeren Kunststoffschicht (9) ansteigt.

2. Kapazitive Sensoranordnung nach Anspruch 1, **dadurch gekennzeichnet, dass** sich zwischen der die Sensorelektrode (2) umgebenden Kunststoffschicht (10) und der äußeren Kunststoffschicht (9) ein gasgefüllter Zwischenraum (11) befindet, dessen Breite dem vorgegebenen Abstand entspricht und dessen relative Dielektrizitätskonstante sich dem Wert 1 annähert.

3. Kapazitive Sensoranordnung nach Anspruch 2, **dadurch gekennzeichnet, dass** der gasgefüllte Zwischenraum (11) von einem Luftspalt oder mehreren Luftspalten mit radialen (13) und/oder zylindrischen Kunststoffzwischenwänden gebildet ist.

4. Kapazitive Sensoranordnung nach Anspruch 2, **dadurch gekennzeichnet, dass** der gasgefüllte Zwischenraum (11) von einem geschäumten Kunststoffbereich gebildet ist.

5. Kapazitive Sensoranordnung nach einem der Ansprüche 1-4, **dadurch gekennzeichnet, dass** die die Sensorelektrode (2) umgebende Kunststoffschicht (10) und/oder die äußere Kunststoffschicht (9) jeweils aus mehreren Kunststoffschichten bestehen.

6. Kapazitive Sensoranordnung nach einem der Ansprüche 1-5, **dadurch gekennzeichnet, dass** der vorgegebene Abstand zwischen der die Sensorelektrode (2) umgebenden Kunststoffschicht (10) und der äußeren Kunststoffschicht (9) im Bereich zwischen 30% und 90%, vorzugsweise im Bereich zwischen 50% und 70%, des Abstands der äußeren Oberfläche der äußeren Kunststoffschicht (9) von der Oberfläche der Sensorelektrode (2) liegt.

7. Kapazitive Sensoranordnung nach einem der Ansprüche 1-5, **dadurch gekennzeichnet, dass** die erste Dicke und die zweite Dicke im Bereich zwischen 0,2 mm und 2 mm liegen.

8. Kapazitive Sensoranordnung nach einem der Ansprüche 1-7, **dadurch gekennzeichnet, dass** der vorgegebene Abstand zwischen der die Sensorelektrode (2) umgebenden Kunststoffschicht (10) und der äußeren Kunststoffschicht (9) im Bereich zwischen 0,5 mm und 10 mm, vorzugsweise im Bereich zwischen 1 mm und 4 mm, liegt.

9. Kapazitive Sensoranordnung nach einem der Ansprüche 1-8, **dadurch gekennzeichnet, dass** sich der Detektionsbereich der Sensoranordnung (1) in einem vorgegebenen Winkelbereich (α) zwischen jeweils 40° bis 130° zu beiden Seiten der von der ersten und der zweiten Koordinatenlinie aufgespannten Ebene (7) erstreckt.

10. Kapazitive Sensoranordnung nach einem der Ansprüche 1-9, **dadurch gekennzeichnet, dass** die Sensorelektrode (2) auf der der Schirmelektrode (3) zugewandten Seite sowie die Schirmelektrode (3) und die Hintergrundelektrode (4) von einem Kunststoffmantel umhüllt sind, wobei der Kunststoffmantel die Elektroden (2, 3, 4) trägt und ihre Position fixiert.

11. Kapazitive Sensoranordnung nach einem der Ansprüche 1-10, **dadurch gekennzeichnet, dass** die Hintergrundelektrode (4) als ebene Platte ausgebildet ist, die in einer zu der zweiten Koordinatenlinie senkrechten Ebene symmetrisch hinter der Sensorelektrode (2) angeordnet ist.

12. Kapazitive Sensoranordnung nach Anspruch 11, **dadurch gekennzeichnet, dass** sich die Hintergrundelektrode (4) in der zur ersten und zur zweiten Koordinatenlinie senkrechten Richtung bis zur äußeren Kunststoffschicht (9) der in der Art eines halbkreisförmigen oder halbelliptischen Zylinders angeordneten Isolatormaterialien erstreckt.

13. Kapazitive Sensoranordnung nach Anspruch 11 oder 12, **dadurch gekennzeichnet, dass** die Schirmelektrode (3) in der zur ersten und zur zweiten Koordinatenlinie senkrechten Richtung eine Breite aufweist, die größer als die der Sensorelektrode (2), aber geringer als die der Hintergrundelektrode (4) ist.

14. Kapazitive Sensoranordnung nach einem der Ansprüche 1-13, **dadurch gekennzeichnet, dass** das Referenzpotential Masse ist und dass die Hintergrundelektrode (4) eine Masse-Elektrode ist.

15. Kapazitive Sensoranordnung nach einem der Ansprüche 1-14, **dadurch gekennzeichnet, dass** die vorgegebene Frequenz im Bereich zwischen 50 kHz und 5 MHz, vorzugsweise zwischen 100 kHz und 1 MHz, liegt.

## Claims

1. Capacitive sensor array (1) comprising:
a sensor electrode (2) that extends along a first coordinate line, by means of which the entry of an object into a space (8) in front of the sensor electrode (2) is intended to be detected,
a control and evaluation circuit (5) coupled with the sensor electrode (2), which detects a change in the capacity of the sensor electrode (2) as compared to a reference potential by periodically charging and discharging the sensor electrode (2) at a predetermined frequency and evaluating at least one parameter of a current or voltage flow that is dependent on the periodic charging and discharging of the sensor electrode (2) in order to detect the capacity change,
a background electrode (4) that extends parallel to the sensor electrode (2),
a shielding electrode (3) that is arranged between the sensor electrode (2) and the background electrode (4) and coupled with the sensor electrode (2) via the control and evaluation circuit (5) in such a way that its potential substantially follows the potential of the sensor electrode (2),
wherein the sensor electrode (2), the shielding electrode (3) and the background electrode (4) are arranged behind each other along a second coordinate line that is perpendicular to the first coordinate line, wherein a detection region of the sensor array (1) extends in the direction of the second coordinate line into the space (8) in front of the sensor electrode (2) and within a specified angular range (α) on both sides of the plane (7) that is spanned by the first and second coordinate lines,
wherein the sensor electrode (2) is surrounded by insulating materials which are arranged between the sensor electrode (2) and the detection region in the manner of a semi-circular or semi-elliptical cylinder, wherein the central axis of the cylinder lies within the plane (7) that is spanned by the first and second coordinate lines, wherein the insulator materials between the detection region and the sensor electrode (2) include at least one plastics layer (10) of a first thickness that directly surrounds the sensor electrode (2) and an outer plastics layer (9) of a second thickness that is arranged at a predetermined distance, wherein the insulator materials are arranged such that the relative dielectric constant initially assumes a relatively high value of the surrounding plastics layer (10) as the distance from the sensor electrode (2) increases, then drops to a value that approaches the value of 1 and then again rises to a relatively high value of the outer plastics layer (9).

2. Capacitive sensor array according to claim 1, **characterised in that** there is a gas-filled intermediate space (11) between the plastics layer (10) surrounding the sensor electrode (2) and the outer plastics layer (9), the width of which corresponds to the predetermined distance and the relative dielectric constant of which approaches the value of 1.

3. Capacitive sensor array according to claim 2, **characterised in that** the gas-filled intermediate space (11) is formed by an air gap or a plurality of air gaps having radial (13) and/or cylindrical plastics dividing walls.

4. Capacitive sensor array according to claim 2, **characterised in that** the gas-filled intermediate space (11) is formed by a foamed plastics region.

5. Capacitive sensor array according to any of claims 1 to 4, **characterised in that** the plastics layer (10) surrounding the sensor electrode (2) and/or the outer plastics layer (9) each consist of a plurality of plastics layers.

6. Capacitive sensor array according to any of claims 1 to 5, **characterised in that** the predetermined distance between the plastics layer (10) surrounding the sensor electrode (2) and the outer plastics layer (9) lies within the range of between 30 % and 90 %, preferably within the range of between 50 % and 70 %, of the distance of the outer surface of the outer plastics layer (9) from the surface of the sensor electrode (2).

7. Capacitive sensor array according to any of claims 1 to 5, **characterised in that** the first thickness and the second thickness lie within the range of between 0.2 mm and 2 mm.

8. Capacitive sensor array according to any of claims 1 to 7, **characterised in that** the predetermined distance between the plastics layer (10) surrounding the sensor electrode (2) and the outer plastics layer (9) lies within the range of between 0.5 mm and 10 mm, preferably within the range of between 1 mm and 4 mm.

9. Capacitive sensor array according to any of claims 1 to 8, **characterised in that** the detection region of the sensor array (1) extends within a specified angular range (α) of between 40° and 130° to both sides of the plane (7) spanned by the first and second coordinate lines.

10. Capacitive sensor array according to any of claims 1 to 9, **characterised in that** the sensor electrode (2) on the side facing the shielding electrode (3) and the shielding electrode (3) and the background electrode (4) are covered by a plastics casing, the plastics casing supporting the electrodes (2, 3, 4) and fixing the positions thereof.

11. Capacitive sensor array according to any of claims 1 to 10, **characterised in that** the background electrode (4) is formed as a planar plate that is symmetrically arranged behind the sensor electrode (2) in a plane that is perpendicular to the second coordinate line.

12. Capacitive sensor array according to claim 11, **characterised in that** the background electrode (4) extends in the direction that is perpendicular to the first and second coordinate lines to the outer plastics layer (9) of the insulator materials that are arranged in the manner of a semi-circular or semi-elliptical cylinder.

13. Capacitive sensor array according to either claim 11 or claim 12, **characterised in that** the shielding electrode (3) has a width in the direction that is perpendicular to the first and second coordinate lines which is greater than that of the sensor electrode (2) but less than that of the background electrode (4).

14. Capacitive sensor array according to any of claims 1 to 13, **characterised in that** the reference potential is ground and **in that** the background electrode (4) is a ground electrode.

15. Capacitive sensor array according to any of claims 1 to 14, **characterised in that** the predetermined frequency lies within the range of between 50 kHz and 5 MHz, preferably of between 100 kHz and 1 MHz.

## Revendications

1. Aménagement de capteur capacitif (1), comprenant :
une électrode de détection (2) s'étendant le long d'une première ligne de coordonnées, à l'aide de laquelle électrode la pénétration d'un objet dans un espace (8) devant l'électrode de détection (2) doit être détectée,
un circuit de commande et d'évaluation (5) couplé à l'électrode de détection (2), lequel circuit détecte une variation de la capacité de l'électrode de détection (2) par rapport à un potentiel de référence en faisant en sorte qu'il charge et décharge périodiquement l'électrode de détection (2) à une fréquence prédéterminée et évaluer au moins un paramètre d'un circuit de courant ou de tension dépendant des chargement et déchargement périodiques de l'électrode de détection (2) pour détecter la variation de capacité,
une électrode de fond (4) s'étendant en parallèle avec l'électrode de détection (2),
une électrode de protection (3) aménagée entre l'électrode de détection (2) et l'électrode de fond (4), laquelle électrode de protection est couplée via le circuit de commande et d'évaluation (5) avec l'électrode de détection (2) de sorte que son potentiel soit sensiblement asservi au potentiel de l'électrode de détection (2),
dans lequel l'électrode de détection (2), l'électrode de protection (3) et l'électrode de fond (4) sont aménagées l'une derrière l'autre le long d'une seconde ligne de coordonnées perpendiculaire à la première ligne de coordonnées, dans lequel une zone de détection de l'aménagement de capteur (1) s'étend dans la direction de la seconde ligne de coordonnées dans l'espace (8) situé devant l'électrode de détection (2) ainsi que dans une plage angulaire prédéterminée (α) avec les deux côtés du plan (7) formé par les première et seconde lignes de coordonnées,
dans lequel l'électrode de détection (2) est entourée par des matériaux isolants, qui sont aménagés entre l'électrode de détection (2) et la zone de détection sous la forme d'un cylindre semi-circulaire ou semi-elliptique, dans lequel l'axe central du cylindre se trouve dans le plan (7), qui est sous-tendu par les première et seconde lignes de coordonnées, dans lequel les matériaux isolants entre la zone de détection et l'électrode de détection (2) comprennent au moins une couche de matière plastique (10), entourant directement l'électrode de détection (2), d'une première épaisseur et une couche de matière plastique externe (9), aménagée à une distance prédéterminée, d'une seconde épaisseur, dans lequel les matériaux isolants sont aménagés de sorte que la constante diélectrique relative adopte à distance croissante de l'électrode de détection (2) tout d'abord une valeur relativement élevée de la couche de matière plastique enveloppante (10), puis chute à une valeur se rapprochant de la valeur 1 pour ré-augmenter ensuite à une valeur relativement élevée de la couche de matière plastique externe (9).

2. Aménagement de capteur capacitif selon la revendication 1, **caractérisé en ce qu'**entre la couche de matière plastique (10) entourant l'électrode de détection (2) et la couche de matière plastique externe (9) se trouve un espace intermédiaire (11) rempli de gaz, dont la largeur correspond à la distance prédéterminée et dont la constante diélectrique relative se rapproche de la valeur 1.

3. Aménagement de capteur capacitif selon la revendication 2, **caractérisé en ce que** l'espace intermédiaire (11) rempli de gaz est formé par un intervalle d'air ou plusieurs intervalles d'air avec des parois intermédiaires radiales (13) et/ou cylindriques en matière plastique.

4. Aménagement de capteur capacitif selon la revendication 2, **caractérisé en ce que** l'espace intermédiaire (11) rempli de gaz est formé par une zone de matière plastique expansée.

5. Aménagement de capteur capacitif selon l'une quelconque des revendications 1 à 4, **caractérisé en ce que** la couche de matière plastique (10) entourant l'électrode de détection (2) et/ou la couche de matière plastique externe (9) sont respectivement constituées de plusieurs couches de matière plastique.

6. Aménagement de capteur capacitif selon l'une quelconque des revendications 1 à 5, **caractérisé en ce que** la distance prédéterminée entre la couche de matière plastique (10) entourant l'électrode de détection (2) et la couche de matière plastique externe (9) se situe dans la plage comprise entre 30 % et 90 %, de préférence dans la plage comprise entre 50 % et 70 %, de la distance de la surface externe de la couche de matière plastique externe (9) à la surface de l'électrode de détection (2).

7. Aménagement de capteur capacitif selon l'une quelconque des revendications 1 à 5, **caractérisé en ce que** la première épaisseur et la seconde épaisseur se situent dans la plage comprise entre 0,2 mm et 2 mm.

8. Aménagement de capteur capacitif selon l'une quelconque des revendications 1 à 7, **caractérisé en ce que** la distance prédéterminée entre la couche de matière plastique (10) entourant l'électrode de détection (2) et la couche de matière plastique externe (9) se situe dans la plage comprise entre 0,5 mm et 10 mm, de préférence dans la plage comprise entre 1 mm et 4 mm.

9. Aménagement de capteur capacitif selon l'une quelconque des revendications 1 à 8, **caractérisé en ce que** la zone de détection de l'aménagement de capteur (1) s'étend dans une zone angulaire prédéterminée (α) comprise entre respectivement 40° et 130° des deux côtés du plan (7) sous-tendu par les première et seconde lignes de coordonnées.

10. Aménagement de capteur capacitif selon l'une quelconque des revendications 1 à 9, **caractérisé en ce que** l'électrode de détection (2) du côté tourné vers l'électrode de protection (3) ainsi que l'électrode de protection (3) et l'électrode de fond (4) sont enrobées par une chemise de matière plastique, la chemise de matière plastique portant les électrodes (2, 3, 4) et fixant leur position.

11. Aménagement de capteur capacitif selon l'une quelconque des revendications 1 à 10, **caractérisé en ce que** l'électrode de fond (4) se présente sous la forme d'une plaque plane, qui est aménagée dans un plan perpendiculaire à la seconde ligne de coordonnées de manière symétrique derrière l'électrode de détection (2).

12. Aménagement de capteur capacitif selon la revendication 11, **caractérisé en ce que** l'électrode de fond (4) s'étend dans la direction perpendiculaire à la première et à la seconde ligne de coordonnées jusqu'à la couche de matière plastique externe (9) des matériaux isolants aménagés sous la forme d'un cylindre de forme semi-circulaire ou semi-elliptique.

13. Aménagement de capteur capacitif selon la revendication 11 ou 12, **caractérisé en ce que** l'électrode de protection (3) présente dans la direction perpendiculaire aux première et seconde lignes de coordonnées une largeur qui est plus grande que celle de l'électrode de détection (2), mais plus petite que celle de l'électrode de fond (4).

14. Aménagement de capteur capacitif selon l'une quelconque des revendications 1 à 13, **caractérisé en ce que** le potentiel de référence est la masse et **en ce que** l'électrode de fond (4) est une électrode de masse.

15. Aménagement de capteur capacitif selon l'une quelconque des revendications 1 à 14, **caractérisé en ce que** la fréquence prédéterminée se situe dans la plage comprise entre 50 kHz et 5 MHz, de préférence entre 100 kHz et 1 MHz.
